(19) **Europäisches Patentamt**

**European Patent Office**

**Office européen des brevets**

(11) Veröffentlichungsnummer: **0 214 532**
**A2**

# (12) EUROPÄISCHE PATENTANMELDUNG

(21) Anmeldenummer: **86111617.6**

(22) Anmeldetag: **22.08.86**

(51) Int. Cl.4: **H01R 11/28** , G01R 15/02 ,
G01R 1/20 , H01M 2/30 ,
H01M 10/48 , B60R 16/04

(30) Priorität: **09.09.85 DE 3532044**

(43) Veröffentlichungstag der Anmeldung:
**18.03.87 Patentblatt 87/12**

(84) Benannte Vertragsstaaten:
**DE FR GB IT NL SE**

(71) Anmelder: **VDO Adolf Schindling AG**
**Gräfstrasse 103**
**D-6000 Frankfurt/Main(DE)**

(72) Erfinder: **Pfeifer, Thomas**
**Burgstrasse 6**
**D-6239 Eppstein(DE)**
Erfinder: **Grgec-Messner, Ivan**
**Eppsteiner Strasse 4**
**D-6234 Kelkheim-Fischbach(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Polklemme.**

(57) Eine Polklemme ist als Zwischenstück ausgebildet und weist nach unten hin ein Klemmstück (3) zum Befestigen an einem üblichen Batteriepol und nach oben hin einen Polkörper (2) auf, an dem eine übliche Batterieklemme befestigbar ist. In der Polklemme sind ein Hallelement (12) und eine Auswertelektronik (7) vorgesehen, so daß der Stromfluß durch den Polkörper (2) meßbar ist.

FIG. 3

EP 0 214 532 A2

## Polklemme

Die Erfindung bezieht sich auf eine Polklemme für Akkumulatorenbatterien, welche Anschlüsse für eine Anzeige-oder Meßeinrichtung aufweist. Solche Polklemmen sind allgemein bekannt.

Bei Kraftfahrzeugen werden üblicherweise auf die Pole der Akkumulatorenbatterien Polklemmen gesetzt, um die Pole mit dem elektrischen Netz des Kraftfahrzeugs zu verbinden. Bei den Polklemmen handelt es sich um Klemmschellen, welche mittels jeweils einer Klemmschraube fest auf den jeweiligen Pol geklemmt werden können.

Beim Aufladen von Akkumulatorenbatterien ist es erforderlich, den durch die Pole fließenden Strom zu messen, um den richtigen Zeitpunkt für das Abschalten des Ladegerätes zu finden. Weiterhin ist es wünschenswert, auch bei Benutzung einer Akkumulatorenbatterie ihren Ladezustand überwachen zu können, um die Akkumulatorenbatterie beispielsweise durch Benutzung eines Autoradios nicht so weit zu entladen, daß zuwenig Strom für einen Startvorgang zur Verfügung steht. Eine solche Überwachung bedingt eine Anschlußmöglichkeit an der Polklemme für die Anschlußkabel eines Anzeige-oder Meßgerätes. Zum Anschluß der erforderlichen Kabel ist es bekannt, an der Polklemme, die die Akkumulatorenbatterie mit dem Bordnetz verbindet, zusätzliche Anschlüsse vorzusehen.

Wenn eine Batterie außerhalb des Fahrzeugs aufgeladen wird, dann sind die Polklemmen zuvor von der Batterie zu lösen. Beim Aufladen ist man deshalb auf einen provisorischen Anschluß das Anzeige-oder Meßgerätes angewiesen.

Der Erfindung liegt die Aufgabe zugrunde, eine Polklemme der eingangs genannten Art derart zu gestalten, daß ein Anzeige-oder Meßgerät auch dann zuverlässig an ihr angeschlossen werden kann, wenn die Akkumulatorenbatterie nicht vom Bordnetz getrennt ist.

Diese Aufgabe wird erfindungsgemäß dadurch gelöst, daß die Polklemme als Zwischenstück mit einem entsprechend dem Batteriepol ausgebildeten Polkörper zum Anschluß einer üblichen, ein Batteriekabel aufweisenden Anschlußklemme ausgebildet ist, wobei der Polkörper einen den am Batteriepol fließenden Stromsensor aufweist.

Durch diese Gestaltung kann die Polklemme ständig am Pol der Akkumulatorenbatterie befestigt bleiben. Das die Batterie mit dem Bordnetz verbindende Kabel kann mit einer weiteren, im Aufbau üblichen Polklemme an der erfindungsgemäßen Polklemme befestigt werden. Dadurch kann das Anzeige-oder Meßgerät unabhängig davon, ob die Batterie mit dem Bordnetz verbunden ist oder nicht, an die Batterie angeschlossen werden. Deshalb ist sowohl eine Überwachung der vom Bordnetz abgetrennten Batterie als auch eine Überwachung während des Betriebs eines mit der Batterie verbundenen Fahrzeugs möglich.

Konstruktiv besonders vorteilhaft ist es, wenn der Polkörper für die Anschlußklemme ein Klemmstück zur Befestigung der Polklemme auf einem Batteriepol besitzt. Bei einer solchen Ausführungsform kann man wie gewohnt die mit einem Anschlußkabel versehene,übliche Polklemme von oben her auf die erfindungsgemäße Polklemme aufsetzen und festschrauben.

Polkörper und Klemmstück sind vorzugsweise koaxial zueinander angeordnet. Die Anschlüsse für eine Anzeige-und Meßeinrichtung können an einem Gehäuse vorgesehen sein, welches fest mit dem Polkörper verbunden ist.

Der durch den Batteriepol fließende Strom ist besonders einfach und zuverlässig zu messen, wenn der Polkörper von einem Ringkern umschlossen ist, der einen radialen Spalt aufweist, in dem ein den Stromsensor bildendes Hallelement angeordnet ist.

Umschließt der Ringkern einen radial umlaufenden Flansch des Polkörpers, so bildet der Flansch ein einfaches Halteteil für den Ringkern.

Ist das Gehäuse den Ringkern und gegebenenfalls den Flansch umschließend ausgebildet, wird eine sichere Verkapselung zum Schutz dieser Teile nach außen erreicht.

Auf eine außerhalb der Polklemme angeordnete Auswerteelektronik kann verzichtet werden, wenn in dem Gehäuse eine Auswerteelektronik zur Verarbeitung der Hallspannung des Hallelements angeordnet ist.

Die oben beschriebene Ausbildung der Polklemme hat den Vorteil, daß eine galvanische Trennung der Auswerteelektronik von der Polklemme gewährleistet ist.

Die Erfindung läßt zahlreiche Ausführungsformen zu. Eine davon ist in der Zeichnung dargestellt und wird nachfolgend beschrieben. Die Zeichnung zeigt in

Fig. 1 eine Seitenansicht der erfindungsgemäßen Polklemme,

Fig. 2 eine teilweise abgebrochen dargestellte Draufsicht auf die Polklemme nach Fig. 1

Fig. 3 einen vertikalen Schnitt durch die Polklemme nach den Figuren 1 und 2,

Fig. 4 einen horizontalen Teilschnitt durch die Polklemme entlang der Linie IV -IV in Fig. 3

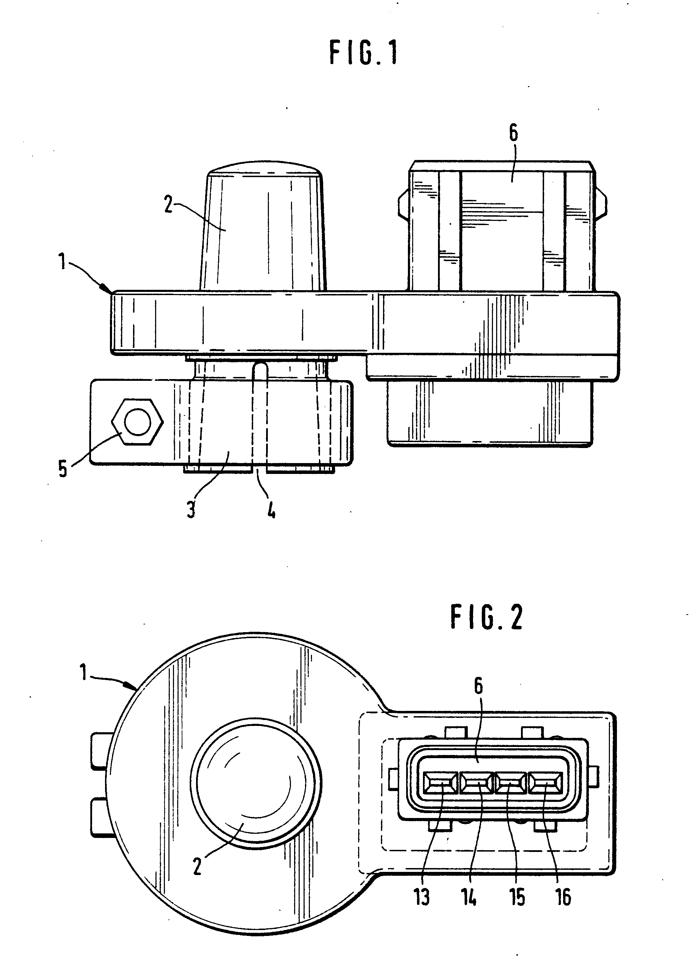

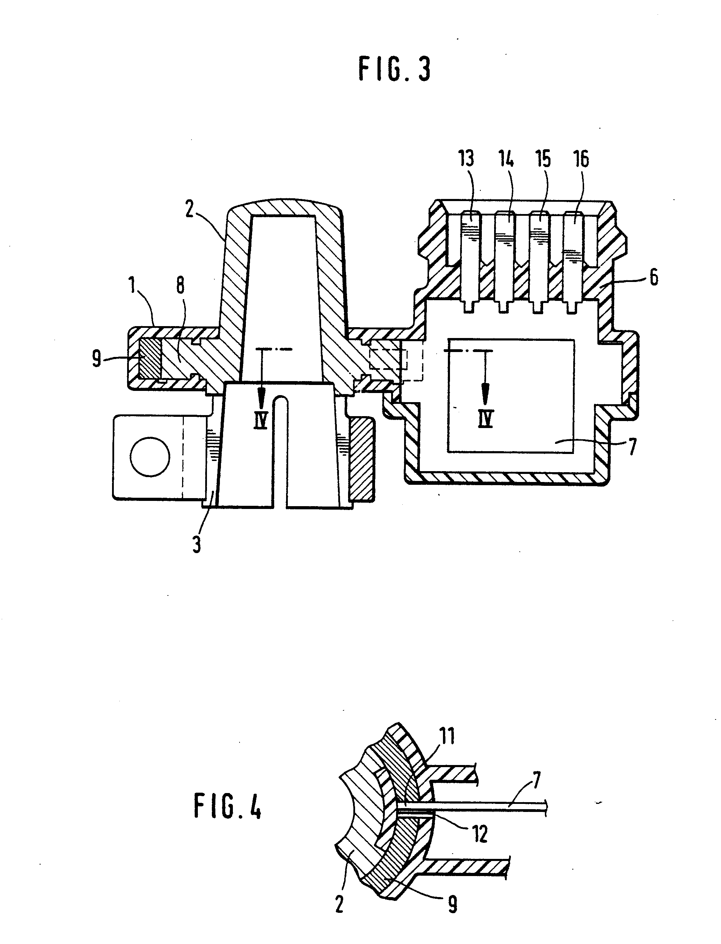

Wie die Figur 1 zeigt, besitzt die erfindungsgemäße Polklemme einen Kunststoffkörper 1, aus dem nach oben hin ein Polkörper 2 aus elektrisch leitendem Material ragt. Dieser Polkörper 2 ist genau wie ein üblicher Batteriepol geformt, so daß auf ihn eine übliche, die Akkumulatorenbatterie mit einem Bordnetz verbindende Anschlußklemme geklemmt werden kann. Koaxial zum Polkörper 2 ragt nach unten hin aus dem Kunststoffkörper 1 ein Klemmstück 3, welches Schlitze 4 aufweist und welches auf einen üblichen Batteriepol geschoben werden kann. Mittels einer Klemmschraube 5 kann das Klemmstück 3 gespannt werden, so daß es auf dem Batteriepol gehalten ist. Seitlich des Polkörpers 2 und des Klemmstückes 3 ist der Kunststoffkörper 1 mit einem geschlossenen Gehäuse 6 verbunden, in dem eine in Figur 3 durch einen Block angedeutete Auswertelektronik 7 angeordnet ist.

Die in Figur 2 gezeigte Draufsicht auf die Anordnung nach Figur 1 verdeutlicht die Gestaltung der vorgenannten Bauteile.

Die Figur 3 läßt den inneren Aufbau der Polklemme erkennen. Zu sehen ist, daß der Polkörper 2 einen radial umlaufenden Flansch 8 besitzt. Dieser Flansch 8 ist von einem Ringkern 9 umschlossen, wobei Ringkern 9 und Flansch 8 durch den Kunststoffkörper umschlossen sind.

Wie die Figur 4 erkennen läßt, weist der Ringkern 9 einen Spalt 11 auf, in dem ein Hallelement 12 angeordnet ist. Dieses Hallelement 12 hat VErbindung mit der Auswertelektronik 7, so daß mit ihr der durch den Polkörper 2 fließende Strom gemessen werden kann. In der Figur 3 gezeigte Anschlüsse 13, 14, 15, 16 am Gehäuse 6 erlauben es, diese Auswertelektronik 7 z.B. mit einem nicht gezeigten Anzeigeinstrument, welches den Stromfluß durch den Polkörper 2 anzuzeigen vermag oder einer Regelelektronik zu verbinden.

**Ansprüche**

1. Polklemme für Akkumulatorenbatterien, welche Anschlüsse für eine Anzeige-oder Meßeinrichtung aufweist, dadurch gekennzeichnet, daß die Polklemme als Zwischenstück mit einem entsprechend dem Batteriepol ausgebildeten Polkörper (2) zum Anschluß einer üblichen, ein Batteriekabel aufweisenden Anschlußklemme ausgebildet ist, wobei der Polkörper (2) einen den am Batteriepol fließenden Strom erfassenden Stromsensor aufweist.

2. Polklemme nach Anspruch 1, dadurch gekennzeichnet, daß der Polkörper (2) für die Anschlußklemme ein Klemmstück (3) zur Befestigung der Polklemme auf einem Batteriepol besitzt.

3. Polklemme nach Anspruch 2, dadurch gekennzeichnet, daß Polkörper (2) und Klemmstück - (3) koaxial zueinander angeordnet sind.

4. Polklemme nach einem der vorhergehenden Ansprüche dadurch gekennzeichnet, daß die Anschlüsse (13 -16) für eine anzeige-oder Meßeinrichtung an einem Gehäuse (6) vorgesehen sind, welches festmit dem Polkörper (2) verbunden ist.

5. Polklemme nach einem der vorhergehenden Ansprüche, dadurch gekennzeichnet, daß der Polkörper (2) von einem Ringkern (9) umschlossen ist, der einen radialen Spalt (11) aufweist, in dem ein den Stromsensor bildendes Hallelement (12) angeordnet ist.

6. Polklemme nach Anspruch 5, dadurch gekennzeichnet, daß der Ringkern (9) einen radial umlaufenden Flansch (8) des Polkörpers (2) umschließt.

7. Polklemme nach einem der vorhergehenden Ansprüche, dadurch gekennzeichnet, daß das Gehäuse (6) den Ringkern (9) und gegebenenfalls den Flansch (8) umschließend ausgebildet ist.

8. Polklemme nach einem der vorhergehenden Ansprüche, dadurch gekennzeichnet, daß in dem Gehäuse (6) eine Auswerteelektronik (7) zur Verarbeitung der Hallspannung des Hallelements (12) angeordnet ist.

# FIG.1

# FIG.2

# FIG. 3

# FIG. 4